# EUROPEAN PATENT APPLICATION

(11) **EP 4 831 522 A1**
(43) Date of publication of application: **28.10.2026**
(21) Application number: 25211014.3
(22) Date of filing: 24.10.2025
(51) Int. Cl.: F16L 9/19, F16L 55/033

(54) **FLOW GUIDING MODULE AND GAS SUPPLY DEVICE**

(30) Priority: 22.04.2025 TW 114115072
(71) Applicant: Rayzher Industrial Co., Ltd., Zhubei City, Hsinchu 302054 (TW)
(72) Inventor: WU, Kuen-Yi, 302054 Zhubei City, Hsinchu County (TW); TSAI, Yung-Chin, 302054 Zhubei City, Hsinchu County (TW); CHOU, Ku-Hua, 302054 Zhubei City, Hsinchu County (TW)
(74) Representative: Prinz & Partner mbB

(57) **Abstract**

A flow guiding module (1) and a gas supply device. The flow guiding element (12) includes a transportation element (11) and at least one flow guiding element (12). The transportation element (11) is configured to convey a fluid, and the transportation element (11) has a first opening (111), a second opening (112) and a transportation space (113). The first opening (111) and the second opening (112) are respectively located at two different sides of the transportation element (11), and the transportation space (113) is communicated with the first opening (111) and the second opening (112). The at least one flow guiding element (12) is connected to the transportation element (11) and located in the transportation space (113). The at least one flow guiding element (12) has a main body (120) extending from the first opening (111) to the second opening (112), thereby dividing the transportation space (113) into multiple delivery areas (1131).

## Description

### FIELD OF THE DISCLOSURE

The present invention relates to a flow guiding module and a gas supply device, and more particularly to a flow guiding module and a gas supply device that can be configured to increase wind speed uniformity and airflow moving distance (or airflow delivery distance).

### BACKGROUND OF THE DISCLOSURE

In the particulate dust waste gas treatment system of high-tech manufacturing industry, fine dust needs to be collected before and after many waste gas detoxification processes. Currently, due to piping configurations in semiconductor processing equipment, the outlet wind speed of the gas supply device is significantly reduced. As a result, the airflow output by the gas supply device cannot carry most of the particulate dust to the next waste treatment equipment, causing the particulate dust to accumulate in the gas delivery pipeline, resulting in a significant reduction in the treatment efficiency of the treatment system.

### SUMMARY OF THE DISCLOSURE

In response to the above-referenced technical inadequacy, the present invention provides a flow guiding module and a gas supply device.

In order to solve the above-mentioned problems, one of the technical aspects adopted by the present invention is to provide a flow guiding module, which includes a transportation element and at least one flow guiding element. The transportation element is configured to transport a fluid. The transportation element has a first opening, a second opening and a transportation space, the first opening and the second opening respectively located at two different sides of the transportation element, and the transportation space is communicated with the first opening and the second opening. The at least one flow guiding element is connected to the transportation element and located in the transportation space, and the at least one flow guiding element has a main body extending from the first opening to the second opening to divide the transportation space into a plurality of delivery areas.

In order to solve the above-mentioned problems, another one of the technical aspects adopted by the present invention is to provide a gas supply device, which includes a flow guiding element, a gas injection module and at least one gas supply module. The flow guiding module includes a transportation element and at least one flow guiding element. The transportation element is configured to transport a fluid. The transportation element has a first opening, a second opening and a transportation space, the first opening and the second opening respectively located at two different sides of the transportation element, and the transportation space is communicated with the first opening and the second opening. The at least one flow guiding element is connected to the transportation element and located in the transportation space, and the at least one flow guiding element has a main body extending from the first opening to the second opening to divide the transportation space into a plurality of delivery areas. The gas injection module includes a device body. The device body has a gas delivery chamber and an annular airflow generating chamber formed therein, the device body has a gas input portion disposed on one side thereof, the device body has a gas output portion disposed on another side thereof, the gas output portion is connected to the transportation element, the device body has an airflow inlet portion extending outwardly from a lateral side thereof, the gas delivery chamber, the gas input portion and the gas output portion are communicated with each other, and the gas delivery chamber, the annular airflow generating chamber and the airflow inlet portion are communicated with each other. The at least one gas supply module is connected to the airflow inlet portion.

One of the beneficial effects of the present invention is that the flow guiding module and the gas supply device provided by the present invention can improve the wind speed uniformity and airflow moving distance (or airflow delivery distance) by the above-mentioned technical solution.

These and other aspects of the present invention will become apparent from the following description of the embodiment taken in conjunction with the following drawings and their captions, although variations and modifications therein can be effected without departing from the spirit and scope of the novel concepts of the disclosure.

### BRIEF DESCRIPTION OF THE DRAWINGS

The described embodiments can be better understood by reference to the following description and the accompanying drawings, in which:
FIG. 1 is a schematic view of a gas supply device according to a first embodiment of the present invention;
FIG. 2 is a schematic cross-sectional view of the gas supply device according to the first embodiment of the present invention;
FIG. 3 is a schematic perspective view of a flow guiding module according to the first embodiment of the present invention;
FIG. 4 is a schematic cross-sectional view taken along line IV-IV in FIG. 3;
FIG. 5 is a first schematic cross-sectional view of the flow guiding module according to the first embodiment of the present invention, and is also a schematic cross-sectional view taken along line V-V in FIG. 3;
FIG. 6 is a second schematic cross-sectional view of the flow guiding module according to the first embodiment of the present invention;
FIG. 7 is a first graph showing an airflow test between a gas injection module of the present invention and a conventional gas supply device that are not equipped with the flow guiding module of the present invention;
FIG. 8 is a second graph showing another airflow test between the gas injection module of the present invention and the conventional gas supply device that are equipped with the flow guiding module of the present invention; and
FIG. 9 is a schematic cross-sectional view of the flow guiding module according to a second embodiment of the present invention.

### DETAILED DESCRIPTION OF THE EXEMPLARY EMBODIMENTS

The present invention is more particularly described in the following embodiments and examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" may include plural reference, and the meaning of "in" may include "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [First Embodiment]

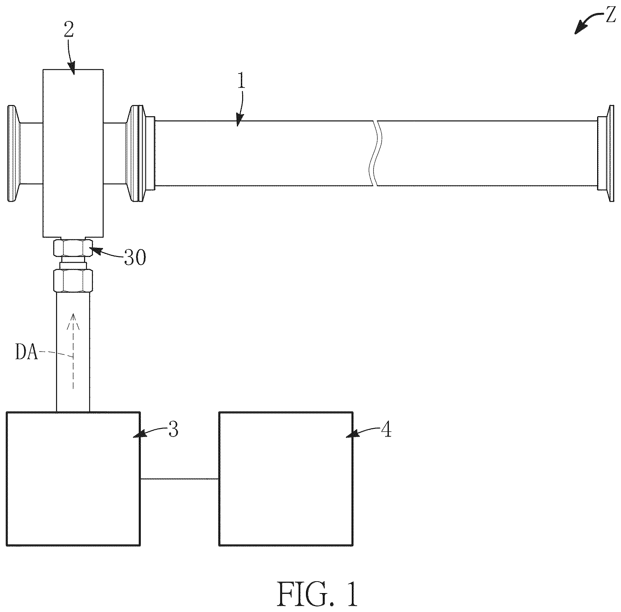

Referring to FIG. 1 to FIG. 8, a first embodiment of the present invention provides a gas supply device Z (or an air supply device), which may include a flow guiding module 1, a gas injection module 2 (or a jet module), and at least one gas supply module 3 (or air source supply module).

Referring to FIG. 1 to FIG. 6, the flow guiding module 1 may include a transportation element 11 (or a conveyance element) and at least one flow guiding element 12. The transportation element 11 can be configured to transport or convey a fluid (such as gas or liquid). The transportation element 11 may have a first opening 111, a second opening 112, and a transportation space 113. The first opening 111 and the second opening 112 are respectively located at one of end sides of the transportation element 11, and the transportation space 113 is communicated with the first opening 111 and the second opening 112. The at least one flow guiding element 12 can be connected to the transportation element 11 and located in the transportation space 113. The main body 120 of the at least one flow guiding element 12 can extend from the first opening 111 to the second opening 112, thereby dividing the transportation space 113 into a plurality of delivery areas 1131, 1132 (or fluid transport spaces, or fluid delivery spaces).

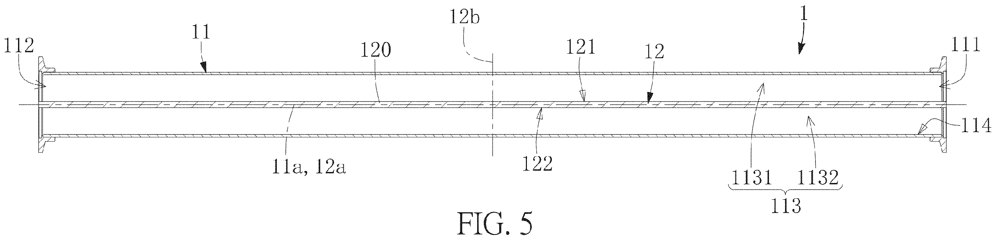

For example, the transportation element 11 can be a tubular structure having a first axis 11a (i.e., a first central axis). The transportation element 11 may have a first opening 111 and a second opening 112 disposed on two opposite end sides of transportation element 11, respectively. The transportation element 11 may have an elongated transportation space 113 formed therein. The flow guiding element 12 can be a plate-shaped structure having a second axis 12a (i.e., a second central axis), the second axis 12a can correspond to the first axis 11a, and the first axis 11a can be parallel to or overlap with the second axis 12a. In this embodiment, the present invention takes the overlap of the first axis 11a and the second axis 12a as an example, but the present invention is not limited thereto. The flow guiding element 12 can be connected to the inner wall 114 of the transportation element 11. An axial cross-section of the flow guiding element 12 parallel to the second axis 12a may have a biconvex mirror shape (as shown in FIG. 5). Alternatively, a radial cross-section of the flow guiding element 12 perpendicular to the second axis 12a may have a biconvex mirror shape (as shown in FIG. 5). The biconvex mirror shape is preferably symmetrical, but the present invention is not limited thereto.

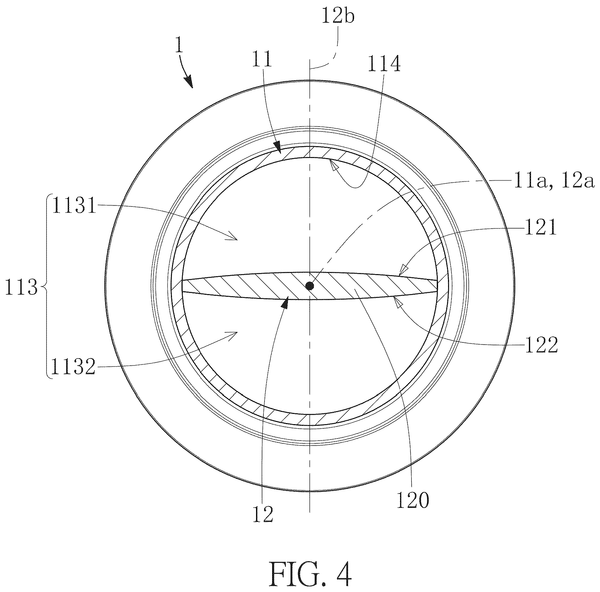

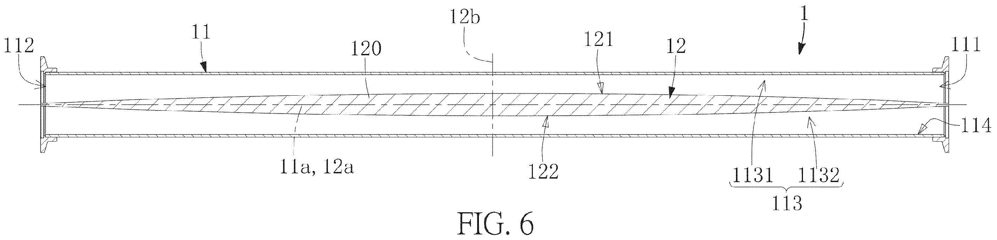

Furthermore, the at least one flow guiding element 12 may further include a radial axis 12b, a first flow guide surface 121, and a second flow guide surface 122. The radial axis 12b can be perpendicular to the second axis 12a. The first flow guide surface 121 can be disposed opposite to the second flow guide surface 122. Specifically, the first flow guide surface 121 can be configured as an upper surface of the flow guiding element 12, and the second flow guide surface 122 can be configured as a lower surface of the flow guiding element 12, but the present invention is not limited thereto. The first flow guide surface 121 and/or the second flow guide surface 122 can be configured as a curved surface relative to the second axis 12a (as shown in FIG. 6), or the first flow guide surface 121 and/or the second flow guide surface 122 can be configured as a curved surface relative to the radial axis 12b (as shown in FIG. 4).

Next, referring to FIG. 1 to FIG. 2, the gas injection module 2 may have a device body 21, and the device body 21 may have a gas delivery chamber 210 and an annular airflow generating chamber 211 formed therein. One side of the device body 21 may have a gas input portion 212, and another side of the device body 21 may have a gas output portion 213. The gas output portion 213 can be connected to the transportation element 11. The device body 21 may have an airflow inlet portion 214 extended outwardly therefrom. The gas delivery chamber 210, the gas input portion 212, and the gas output portion 213 can communicate with each other, and the gas delivery chamber 210, the annular airflow generating chamber 211, and the airflow inlet portion 214 can communicate with each other. For example, the appearance of the device body 21 can be a geometric shape such as a square or a rounded trapezoid, but the present invention is not limited thereto. The gas delivery chamber 210 can be located at the center of the device body 21, and the annular airflow generating chamber 211 can surround and enclose the gas delivery chamber 210. The gas delivery chamber 210 can be a hollow structure. The device body 21 may have a gas input portion 212 and a gas output portion 213 respectively and outwardly extended from two opposite sides thereof. The gas input portion 212, the gas output portion 213, and the airflow inlet portion 214 can be hollow tubular structures. The gas input portion 212 can be communicated with the gas output portion 213 via the gas delivery chamber 210, and the airflow inlet portion 214 can be communicated with the gas delivery chamber 210 via the annular airflow generating chamber 211. The annular airflow generating chamber 211 may have a lateral connection portion 2111 and at least one nozzle portion 2112. The lateral connection portion 2111 and the nozzle portion 2112 can be communicated with each other, and the lateral connection portion 2111 can be connected to the airflow inlet portion 214. The nozzle portion 2112 can be connected to the gas delivery chamber 210. The diameter or aperture of the nozzle portion 2112 can range from 0.01 to 3 mm, preferably 0.1 mm. The nozzle portion 2112 can be configured to generate a propulsion airflow PA (or a motive airflow, or a pushing airflow, or a forced airflow) toward the gas delivery chamber 210 along a predetermined path PR. The predetermined angle PG can be defined between the predetermined path PR and the central axis 21a of the device body 21. The predetermined angle PG can be between 0 and 89 degrees. The predetermined angle PG can preferably range from 0 to 10 degrees, and the best predetermined angle PG may be 0 degrees.

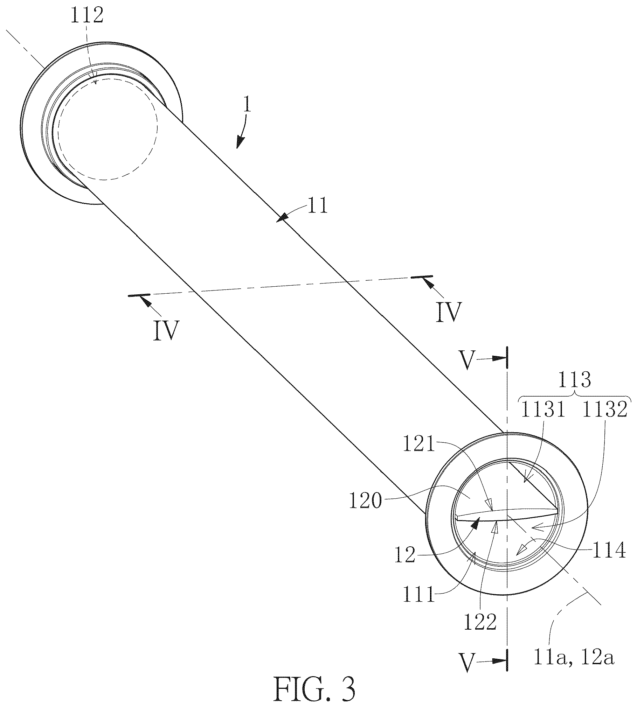

More particularly, the annular airflow generating chamber 211 may have a wing-like cross-section, and the annular airflow generating chamber 211 can be an annular hollow structure. The annular airflow generating chamber 211 may also include a main chamber 2113, and the main chamber 2113 may include a first space (such as a wing-shaped region 2113a) and a second space (such as a shoulder region 2113b). The wing-shaped region 2113a can be connected to the lateral connection portion 2111 and the shoulder region 2113b, and the shoulder region 2113b can be connected to the at least one nozzle portion 2112. The wing-shaped region 2113a may have a conical cross-section, and the shoulder region 2113b may have a C-shape or a hook-shape, but the present invention is not limited thereto. Furthermore, a predetermined inclination angle TG can be defined between the inner wall surface of the device body 21 corresponding to the wing-shaped region 2113a and adjacent to the gas delivery chamber 210 and the central axis 21a of the device body 21. The predetermined inclination angle TG may range from 5 to 30 degrees, preferably 8 degrees, 16 degrees (as shown in FIG. 4), 19 degrees, 26.5 degrees, and 30 degrees (as shown in FIG. 3), but the present invention is not limited thereto.

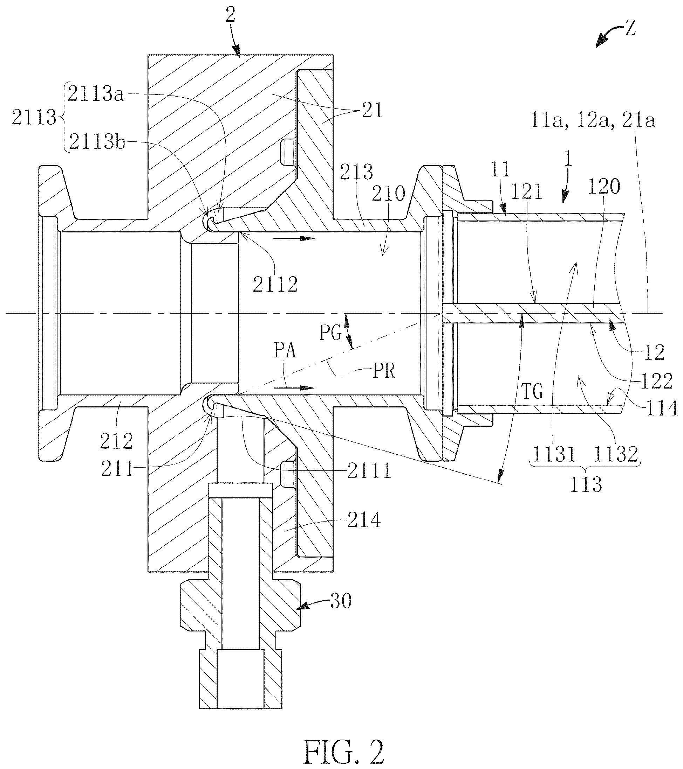

Next, referring to FIG. 1 and FIG. 2, the at least one gas supply module 3 can be connected to the airflow inlet portion 214. For example, the gas supply module 3 can be a gas supply module in a semiconductor device that provides general air or a special gas (such as an inert gas, but the present invention is not limited thereto). The gas supply module 3 may have a connecting pipe 30 connected to the airflow inlet portion 214.

Furthermore, as shown in FIG. 1, the gas supply device Z of the present invention may also include a control module 4, which can be connected to the gas supply module 3. The control module 4 can be configured to control the gas supply module 3 to supply a driving airflow DA to the gas injection module 2 in a continuous or intermittent manner. For example, the control module 4 may be a central control device or a computer.

Therefore, referring to FIG. 1 to FIG. 8, the gas supply device Z of the present invention can be applied to semiconductor process equipment. When the gas supply device Z of the present invention is in operation, the control module 4 can control the gas supply module 3 to supply a driving airflow DA (such as the airflow of an inert gas, but the present invention is not limited thereto) to the gas injection module 2. After the driving airflow DA enters the annular airflow generating chamber 211 through the airflow inlet portion 214, then sequentially flows through the wing-shaped region 2113a and the shoulder region 2113b, then generating a swirl flow in the annular airflow generating chamber 211 (i.e., flowing in the annular airflow generating chamber 211 in a vortex manner), and is then injected into the gas delivery chamber 210 through the nozzle portion 2112. The nozzle portion 2112 can provide (inject) the driving airflow DA toward the gas delivery chamber 210 along a predetermined path PR (i.e., a specific injection direction or a predetermined injection direction), thereby forming the driving airflow DA into the propulsion airflow PA, in which the propulsion airflow PA can be an annular airflow.

Next, when the propulsion airflow PA is injected into the gas delivery chamber 210, the propulsion airflow PA can flow toward the gas output portion 213 along the predetermined path PR (i.e., the predetermined injection direction) and then flow into the transportation space 113. Afterwards, the propulsion airflow PA can flow steadily along the first guide surface 121 and the second guide surface 122 of the flow guiding element 12 without dissipating.

Therefore, the gas supply device Z provided by the above-mentioned technical solution of the present invention can utilize the arrangement or the configuration of the flow guiding module 1 on the gas output portion 213 of the gas injection module 2 and the at least one flow guiding element 12 inside the flow guiding module 1, so that the propulsion airflow PA output by the gas injection module 2 can flow stably along the first guide surface 121 and the second guide surface 122 of the flow guiding element 12 without dissipating after leaving the gas injection module 2, thereby improving wind speed uniformity and airflow moving distance (or airflow delivery distance) of the propulsion airflow PA.

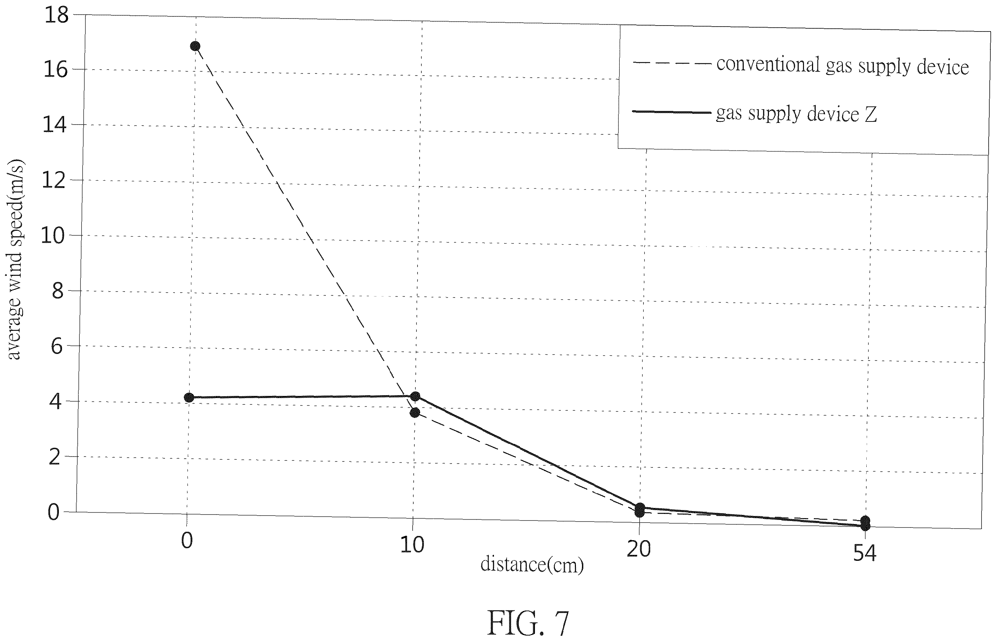

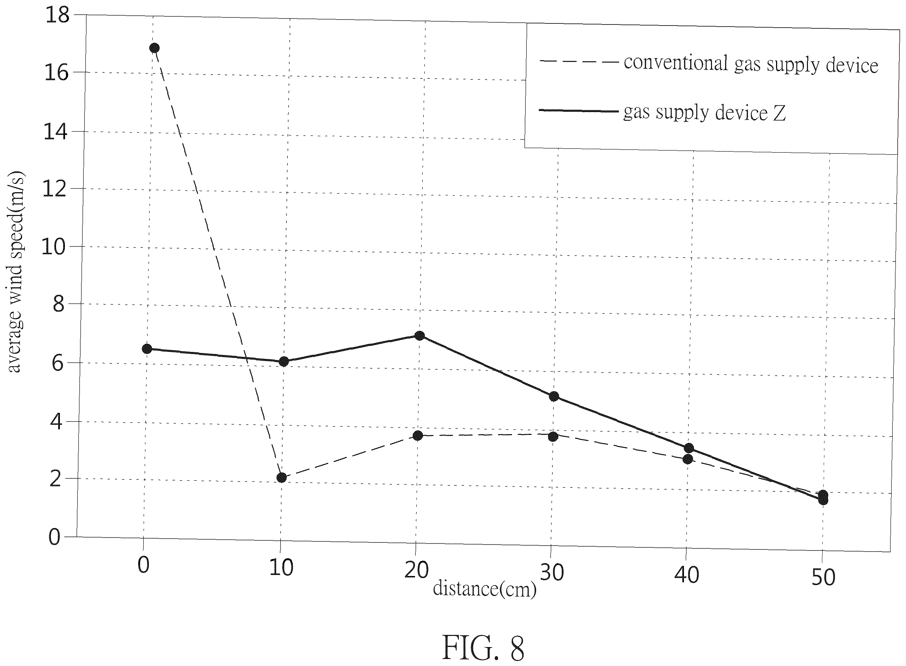

More particularly, referring to FIG. 7, when the gas injection module 2 of the present invention (shown as a solid line) and the conventional gas supply device (shown as a dashed line) are not equipped with the flow guiding module 1 of the present invention, the output airflow (such as having a flow rate about 40 SLM) output (or injected) by the gas injection module 2 and the conventional gas supply device gradually dissipates after flowing to a distance of 20 cm. As shown in FIG. 7, the data (average wind speed) for each node from a distance of 0 to 54 cm for the gas injection module 2 of the present invention are 4.2, 4.4, 0.5, and 0.22 (m/s), and the data (average wind speed) for each node from a distance of 0 to 54 cm for the conventional gas supply device are 16.9, 3.82, 0.45, and 0.27 (m/s). Furthermore, referring to FIG. 8, when the gas injection module 2 of the present invention (shown as a solid line) and the conventional gas supply device (shown as a dashed line) are equipped with the flow guiding module 1 of the present invention, the output airflow (such as having a flow rate about 40 SLM) output (or injected) by the gas injection module 2 and the conventional gas supply device can reach a distance of 50 cm without dissipating, significantly improving wind speed uniformity and airflow moving distance (or airflow delivery distance). As shown in FIG. 8, the data (average wind speed) for the gas injection module 2 of the present invention at each node from a distance of 0 to 50 cm are 6.5, 6.1, 7.1, 5.1, 3.4, and 1.76 (m/s), and the data (average wind speed) for the conventional gas supply device at each node from a distance of 0 to 50 cm are 16.9, 2.18, 3.68, 3.82, 3.07, and 1.9 (m/s).

It is worth noting that the control module 4 of the present invention can control the gas supply module 3 to continuously supply the driving airflow DA to the gas injection module 2 according to a built-in program or manual operation, or can control the gas supply module 3 to intermittently or discontinuously supply the driving airflow DA to the gas injection module 2 at intervals to further increase the blowing distance (for example, providing air every 5 seconds, but the present invention is not limited thereto). Furthermore, the flow rate of the propulsion airflow PA generated by the gas injection module 2 can range from 1 to 600 SLM.

Furthermore, according to the above content, referring to FIG. 1 to FIG. 6, the present invention further provides a flow guiding module 1, which may include a transportation element 11 and at least one flow guiding element 12. The transportation element 11 can be configured to transport or deliver a fluid. The transportation element 11 may have a first opening 111, a second opening 112, and a transportation space 113. The first opening 111 and the second opening 112 can be respectively located at two sides of the transportation element 11, and the transportation space 113 can be communicated with the first opening 111 and the second opening 112. The at least one flow guiding element 12 can be connected to the transportation element 11 and located in the transportation space 113. The main body 120 of the at least one flow guiding element 12 can extend from the first opening 111 to the second opening 112, thereby dividing the transportation space 113 into a plurality of delivery areas 1131, 1132.

### [Second Embodiment]

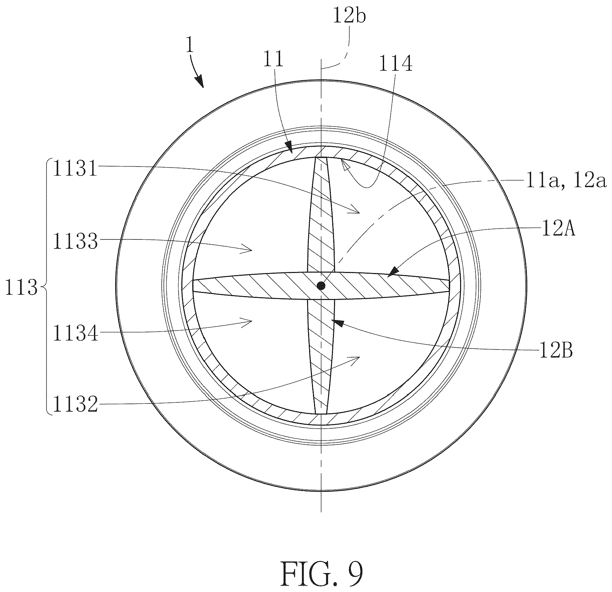

Referring to FIG. 1 to FIG. 9, the gas supply device Z of the second embodiment is substantially similar to the gas supply device Z of the first embodiment, so that the configuration and operation of the same components will not be further described here. The main difference between the second embodiment and the first embodiment is as follows: in the second embodiment, the gas supply device Z can further include a plurality of flow guiding elements 12, and the flow guiding elements 12 can intersect with one another and be located within the transportation space 113. The second axis 12a of one of the flow guiding elements 12 can overlap with the second axis 12a of another one of the flow guiding elements 12, and the radial axis 12b of one of the flow guiding elements 12 can be perpendicular to the radial axis 12b of another one of the flow guiding elements 12.

For example, referring to FIG. 1 to FIG. 6 and FIG. 9, the flow guiding elements 12 may include a first flow guiding element 12A and a second flow guiding element 12B. The length of the first flow guiding element 12A can be greater than the length of the second flow guiding element 12B (for example, the length of the first flow guiding element 12A can be 1.5 to 2 times the length of the second flow guiding element 12B, but the present invention is not limited thereto). One side of the second flow guiding element 12B can be located at the center of the first flow guiding element 12A, and another side of the second flow guiding element 12B can correspond to one side of the first flow guiding element 12A and the second opening 112. That is to say, a portion of the transportation space 113 can be divided into two delivery areas 1131, 1132 by the first flow guiding element 12A, and another portion of the transportation space 113 can be divided into four delivery areas (1131, 1132, 1133, 1134) by the first flow guiding element 12A and the second flow guiding element 12B.

Therefore, when the propulsion airflow PA enters the transportation space 113, the propulsion airflow PA can flow steadily along the upper surface and the lower surface of the first flow guiding element 12A. When the propulsion airflow PA enters the four conveying areas (1131, 1132, 1133, 1134), the propulsion airflow PA can be divided into four sections and flow steadily along the upper surface and the lower surface of the first flow guiding element 12A and the upper surface and the lower surface of the second flow guiding element 12B, without dissipating.

However, the aforementioned details are disclosed for exemplary purposes only, and are not meant to limit the scope of the present invention.

### [Beneficial Effects of the Embodiments]

One of the beneficial effects of the present invention is that the flow guiding module 1 and the gas supply device Z provided by the present invention can improve the wind speed uniformity and airflow moving distance (or airflow delivery distance) by the above-mentioned technical solution.

Furthermore, the gas supply device Z of the present invention can utilize the above-mentioned technical solution to set a flow guiding module 1 at the gas output portion 213 of the gas injection module 2, and configure at least one flow guiding element 12 inside the flow guiding module 1, so that the driving airflow PA output by the gas injection module 2 can flow stably along the first guide surface 121 and the second guide surface 122 of the flow guiding element 12 without dissipating after leaving the gas injection module 2, thereby improving wind speed uniformity and airflow moving distance (or airflow delivery distance) of the propulsion airflow PA.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated.

## Claims

1. A flow guiding module (1), **characterized by** comprising:
a transportation element (11) configured to transport a fluid, wherein the transportation element (11) has a first opening (111), a second opening (112) and a transportation space (113), the first opening (111) and the second opening (112) respectively located at two different sides of the transportation element (11), and the transportation space (113) is communicated with the first opening (111) and the second opening (112); and
at least one flow guiding element (12) connected to the transportation element (11) and located in the transportation space (113), wherein the at least one flow guiding element (12) has a main body (120) extending from the first opening (111) to the second opening (112) to divide the transportation space (113) into a plurality of delivery areas (1131).

2. The flow guiding module (1) according to claim 1, wherein the transportation element (11) has a first axis (11a), and the at least one flow guiding element (12) has a second axis (12a) corresponding to the first axis (11a) of the transportation element (11); and wherein an axial cross-section of the at least one flow guiding element (12) parallel to the second axis (12a) has a biconvex mirror shape, or a radial cross-section of the at least one flow guiding element (12) perpendicular to the second axis (12a) has a biconvex mirror shape.

3. The flow guiding module (1) according to claim 2, wherein the first axis (11a) is parallel to or overlaps with the second axis (12a); and wherein the at least one flow guiding element (12) has a radial axis (12b), a first flow guide surface (121) and a second flow guide surface (122), the radial axis (12b) and the second axis (12a) is perpendicular to each other, the first flow guide surface (121) and the second flow guide surface (122) is disposed opposite to each other, the first flow guide surface (121) is configured as a curved surface relative to the second axis (12a) or the radial axis (12b), and the second flow guide surface (122) is configured as a curved surface relative to the second axis (12a) or the radial axis (12b).

4. The flow guiding module (1) according to claim 3, further comprising a plurality of another flow guiding elements (12), the flow guiding elements (12) intersecting with each other and located in the transportation space (113), the second axis (12a) of one of the flow guiding elements (12) overlapping with the second axis (12a) of another one of the flow guiding elements (12), and the radial axis (12b) of one of the flow guiding elements (12) being perpendicular to the radial axis (12b) of another one of the flow guiding elements (12).

5. The flow guiding module (1) according to claim 4, wherein the flow guiding elements (12) are divided into a first flow guiding element (12A) and a second flow guiding element (12B), a length of the first flow guiding element (12A) is greater than a length of the second flow guiding element (12B), one side of the second flow guiding element (12B) is located at a center of the first flow guiding element (12A), and another side of the second flow guiding element (12B) corresponds to one side of the first flow guiding element (12A) and the second opening (112).

6. A gas supply device, **characterized by** comprising:
a flow guiding element (12) including:
a transportation element (11) configured to transport a fluid, wherein the transportation element (11) has a first opening (111), a second opening (112) and a transportation space (113), the first opening (111) and the second opening (112) respectively located at two different sides of the transportation element (11), and the transportation space (113) is communicated with the first opening (111) and the second opening (112); and
at least one flow guiding element (12) connected to the transportation element (11) and located in the transportation space (113), wherein the at least one flow guiding element (12) has a main body (120) extending from the first opening (111) to the second opening (112) to divide the transportation space (113) into a plurality of delivery areas (1131);
a gas injection module (2) including a device body (21), wherein the device body (21) has a gas delivery chamber (210) and an annular airflow generating chamber (211) formed therein, the device body (21) has a gas input portion (212) disposed on one side thereof, the device body (21) has a gas output portion (213) disposed on another side thereof, the gas output portion (213) is connected to the transportation element (11), the device body (21) has an airflow inlet portion (214) extending outwardly from a lateral side thereof, the gas delivery chamber (210), the gas input portion (212) and the gas output portion (213) are communicated with each other, and the gas delivery chamber (210), the annular airflow generating chamber (211) and the airflow inlet portion (214) are communicated with each other; and
at least one gas supply module (3) connected to the airflow inlet portion (214).

7. The gas supply device according to claim 6,
wherein the transportation element (11) has a first axis (11a), and the at least one flow guiding element (12) has a second axis (12a) corresponding to the first axis (11a) of the transportation element (11);
wherein an axial cross-section of the at least one flow guiding element (12) parallel to the second axis (12a) has a biconvex mirror shape, or a radial cross-section of the at least one flow guiding element (12) perpendicular to the second axis (12a) has a biconvex mirror shape;
wherein the gas supply device further comprises a control module (4) connected to the gas supply module (3), the control module (4) is configured to control the gas supply module (3) to supply a driving airflow (DA) to the gas injection module (2) in a continuous or intermittent manner; and
wherein the annular airflow generating chamber (211) includes a lateral connection portion (2111) and at least one nozzle portion (2112), the lateral connection portion (2111) and the at least one nozzle portion (2112) are in communication with each other, the lateral connection portion (2111) is connected to the airflow inlet portion (214), the at least one nozzle portion (2112) is connected to the gas delivery chamber (210), the at least one nozzle portion (2112) is configured to generate a driving airflow (DA) toward the gas delivery chamber (210) along a predetermined path (PR), and a predetermined angle (PG) defined between the predetermined path (PR) and a central axis (21a) of the device body (21) is between 0 and 89 degrees.

8. The gas supply device according to claim 7, wherein the first axis (11a) is parallel to or overlaps with the second axis (12a); and wherein the at least one flow guiding element (12) has a radial axis (12b), a first flow guide surface (121) and a second flow guide surface (122), the radial axis (12b) and the second axis (12a) is perpendicular to each other, the first flow guide surface (121) and the second flow guide surface (122) is disposed opposite to each other, the first flow guide surface (121) is configured as a curved surface relative to the second axis (12a) or the radial axis (12b), and the second flow guide surface (122) is configured as a curved surface relative to the second axis (12a) or the radial axis (12b).

9. The gas supply device according to claim 8, further comprising a plurality of another flow guiding elements (12), the flow guiding elements (12) intersecting with each other and located in the transportation space (113), the second axis (12a) of one of the flow guiding elements (12) overlapping with the second axis (12a) of another one of the flow guiding elements (12), and the radial axis (12b) of one of the flow guiding elements (12) being perpendicular to the radial axis (12b) of another one of the flow guiding elements (12).

10. The gas supply device according to claim 9, wherein the flow guiding elements (12) are divided into a first flow guiding element (12A) and a second flow guiding element (12B), a length of the first flow guiding element (12A) is greater than a length of the second flow guiding element (12B), one side of the second flow guiding element (12B) is located at a center of the first flow guiding element (12A), and another side of the second flow guiding element (12B) corresponds to one side of the first flow guiding element (12A) and the second opening (112).
